# NEUE EUROPÄISCHE PATENTSCHRIFT

(11) **EP 0 367 971 B2**
(45) Veröffentlichungstag und Bekanntmachung des Hinweises auf die Entscheidung über den Einspruch: **08.05.1996**
(45) Hinweis auf die Patenterteilung: 16.12.1992
(21) Anmeldenummer: 89117990.5
(22) Anmeldetag: 28.09.1989
(51) Int. Cl.: H05K 5/02

(54) **Quaderförmiges Gehäuse zum Einbau von Bauelementen**
Square-shaped casing for fitting a component
Boîtier de forme carrée pour le montage de composants

(30) Priorität: 08.11.1988 DE 8813983 U
(43) Veröffentlichungstag der Anmeldung: 16.05.1990
(73) Patentinhaber: bopla Gehäuse Systeme GmbH, D-32257 Bünde (DE)
(72) Erfinder: Behrendt,Horst, D-4972 Löhne (DE); Niehausmeier,Uwe, D-4986 Rödinghausen (DE)
(74) Vertreter: Patentanwälte Dipl.-Ing. Bodo Thielking Dipl.-Ing. Otto Elbertzhagen

(56) Entgegenhaltungen:
- DE-C- 3 633 248
- DE-U- 8 511 254
- US-A- 2 935 554
- US-A- 3 033 635
- US-A- 4 090 632
- Knürr-Prospekt "optibox 5000 - Das Kunststoffgehäuse" von 10/1986
- Knürr-Prospekt "optibox 5000 - Montageanleitung" von 10/1987

## Beschreibung

Die Erfindung betrifft ein quaderförmiges Gehäuse zum Einbau insbesondere von elekrischen und elektronischen Bauelementen, mit Standfüßen.

Bei derartigen Gehäusen, die vorzugsweise aus Kunststoff bestehen, ist es bisher üblich, die Standfüße entweder fest anzuspritzen oder an der Aufstandsfläche durch mechanische Nacharbeit zu befestigen. Beispielsweise ist es üblich, Gummipuffer an der Unterseite der Gehäuse anzuschrauben.

Aus DE-U-85 11 254 ist ein Gehäuse aus Kunststoff bekannt wobei das Gehäuse zur Aufnahme elektrischer, elektronischer, pneumatischer oder hydraulischer Bauelemente und Baugruppen, geeignet ist, wobei es eine schwenkbar angelenkte Klappe (1) aufweist, die mittels einer Feder (2) ausschwenkbar ist und wobei die Mappe in einer mit der Gehäseaußenfläche zumindest im wesentlichen bündigen Stellung verriegelbar ist und mittels einer Drucktaste (3) zum Ausschwenken entriegelbar ist.

Bei derartigen Gehäusen stellt sich jedoch das Problem, daß sie von verschiedenen Verwendern in unterschiedlicher Weise benutzt werden sollen. Während bei einem Benutzer das Gehäuse mit der Breitseite auf die Unterlage gestellt werden soll, muß das Gehäuse bei einem anderen Benutzer beispielsweise mit einer schmalen Seitenfläche aufstehen. Die Gehäuse werden demzufolge entweder als sogenannte "Hodzontalgehäuse" oder als sogenannte "Vertikalgehäuse" benutzt.

Ausgehend von diesem Problem und dem bekannten Stand der Technik liegt der Erfindung die Aufgabe zugrunde, ein quaderförmiges Gehäuse so auszubilden, daß es universell für unterschiedliche Benutzungsfälle verwendbar ist, mit der Folge, daß jeder Benutzer im Bedarfsfall entscheiden kann, an welcher Stelle die Standfüße befestigt werden sollen. Dabei soll ein einfacher Umbau für unterschiedliche Verwendungsarten möglich sein.

Die Lösung dieser Aufgabe erfolgt erfindungsgemäß mit den Merkmalen des Patentanspruchs 1.

Bei einer bevorzugten Ausführungsform der Erfindung weisen die Standfüße als Verlängerung eines Schenkels ausgebildete Auflagebereiche auf.

Schließlich erweist es sich noch als besonders zweckmäßig, daß die Abdeckstücke und die als Winkelstücke ausgebildeten Standfüße verrastbar in den zugehörigenden Ausnehmungen des Gehäuses befestigbar sind.

Die erfindungsgemäße Ausbildung erlaubt eine schnelle Anpassung der Universalgehäuse an unterschiedliche Bedarfsfälle.

Nachstehend wird eine bevorzugte Ausführungsform der Erfindung anhand der Zeichnung im einzelnen beschrieben. Es zeigen:

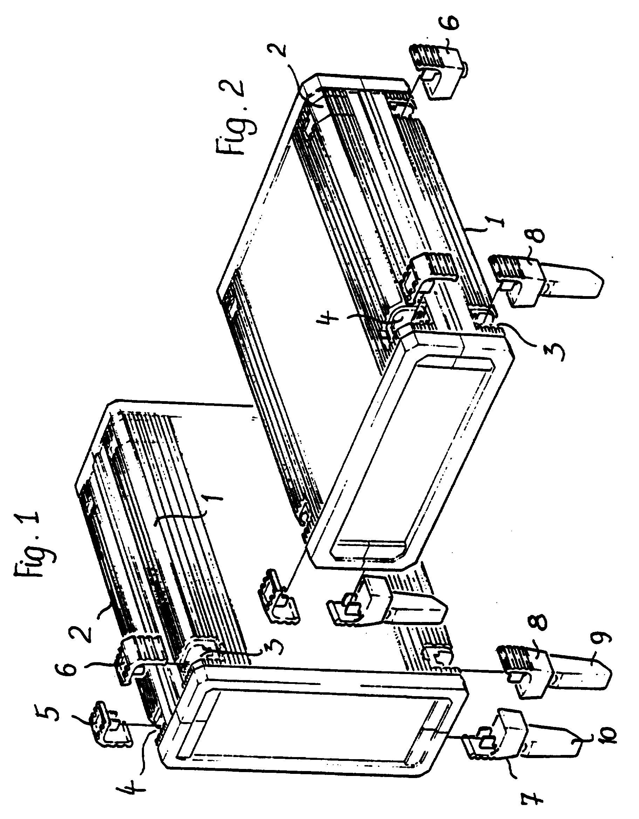

Figur 1 - eine perspektivische Explosionsdarstellung des Gehäuses in vertikaler Position,
Figur 2 - das in Figur 1 dargestellte Gehäuse in Explosionsdarstellung in horizontaler Lage.

Bei dem dargestellten Gehäuse handelt es sich um ein aus Kunststoff bestehendes Frontplattengehäuse. Dieses quaderförmige Gehäuse besitzt vier parallel zueinander verlaufende Kanten, von denen zwei mit den Bezugszeichen 1 und 2 bezeichnet sind. In allen vier Kanten sind jeweils doppelt pro Kante Ausnehmungen vorgesehen, von denen zwei in den Zeichnungen mit den Bezugszeichen 3 und 4 bezeichnet sind. Die Ausnehmungen 3 und 4 erstrecken sich jeweils um die Kanten herum in die zueinander benachbart liegenden Gehäuseflächen. Die Ausnehmungen 3 und 4 können entweder mit Hilfe der als Winkelstücke ausgebildeten Abdeckstücke 5 und 6 verschlossen werden oder mit Hilfe der ebenfalls als Winkelstücke ausgebildeten Standfüße 7 und 8. Bei den Standfüßen erstrecken sich die beispielsweise aus rutschfestem Material bestehenden Auflagebereiche 9 bzw. 10 in Richtung der Verlängerung eines der Schenkel. Die Ausnehmungen und sowohl die Winkelstücke als auch die Abdeckstücke sind so ausgebildet, daß eine Verrastung dieser Teile am Gehäuse in der Einbauposition möglich ist. In welcher Richtung und an welcher Stelle die Winkelstücke eingesetzt werden sollen, hängt lediglich vom Wunsch des Benutzers ab. Der Benutzer kann jegliche ihm geeignet erscheinende Anordnung wählen. Diejenigen Ausnehmungen, die nicht von den Winkelstücken der Standfüße verschlossen sind, werden mit den als Winkelstücken ausgebildeten Abdeckstücken verschlossen.

## Patentansprüche

1. Quaderförmiges Gehäuse zum Einbau insbesondere von elektrischen und elektronischen Bauelementen, mit Standfüßen, seinen Kanten (1; 2) Ausnehmungen (3; 4) aufweist, die sich um die Kanten (1; 2) herum in zueinander benachbart liegende Gehäuseflächen erstrecken und wahlweise mit als Winkelstücke ausgebildeten Abdeckstücken (5; 6) oder als Winkelstücke ausgebildeten Standfüßen (7; 8) verschließbar sind, wobei es vom Wunsch des Benutzers abhängt, in welcher Richtung und an welcher Stelle die Winkelstücke eingesetzt werden.

2. Quaderförmiges Gehäuse nach Anspruch 1,
wobei
die Standfüße (7; 8) als Verlängerung eines Schenkels ausgebildete Auflagebereiche (10; 9) aufweisen.

3. Quaderförmiges Gehäuse nach Anspruch 1 oder 2,
wobei
die Abdeckstücke (5; 6) und die als Winkelstücke ausgebildeten Standfüße (7; 8) verrastbar in den zugehörigen Ausnehmungen (3; 4) des Gehäuses befestigbar sind.

## Claims

1. Rectangular housing for the installation in particular of electrical and electronic components, which has on its edges (1;2) recesses (3;4) which extend around the edges of housing faces which lie adjacent to one another and are selectively closed by cover pieces (5;6) designed as angular sections or by stand feet (7;8) designed as angular sections, whereby it depends on the wish of the user, in which direction and in which position the angular sections are inserted.

2. Rectangular housing according to claim 1 wherein the feet (7;8) have bearing areas (10;9) designed as an extension of an arm.

3. Rectangular housing according to claim 1 or 2 wherein the cover pieces (5;6) and the feet (7;8) designed as angular sections can be fixed by detent connection in the associated recesses (3;4) of the housing.

## Revendications

1. Boitier parallélépipédique, avec pieds, pour le montage d'éléments, notamment de composants électriques et électroniques, le boitier présentant sur ses bords (1; 2) des évidements (3; 4), qui s'étendent autour des bords (1; 2) dans des surfaces adjacentes du boîtier et peuvent être fermés, au choix, à l'aide de pièces de recouvrement (5; 6) coudées ou de pieds (7; 8) en forme de pièces coudées, l'utilisateur pouvant décider à quel endroit et dans quelle direction les pièces coudées doivent être disposées.

2. Boitier parallélépipédique selon la revendication 1,
les pieds (7; 8) présentant des zones d'appui (10; 9) en prolongement d'une aile.

3. Boîtier parallélépipédique selon la revendication 1 ou 2,
les éléments de recouvrement (5; 6) et les pieds (7; 8) en forme de pièces coudées pouvant être fixés par enclenchement dans les évidements (3; 4) correspondants du boîtier.
